# EUROPEAN PATENT APPLICATION

(11) **EP 1 763 298 A2**
(43) Date of publication of application: **14.03.2007**
(21) Application number: 06115157.7
(22) Date of filing: 08.06.2006
(51) Int. Cl.: H05K 9/00

(54) **Methods of electromagnetically shielding buildings and bitumen panels useful therein**

(30) Priority: 11.09.2005 IL 17079105
(71) Applicant: First, Moshe, 47293 Ramat-HaSharon (IL)
(72) Inventor: First, Moshe, 47293 Ramat-HaSharon (IL)
(74) Representative: Weydert, Robert

(57) **Abstract**

A panel of electromagnetic shielding material for use in shielding a building structure or other enclosure from electromagnetic radiation, includes two layers of bitumen bonded to, and on opposite sides of, an electromagnetic screen having a plurality of electrically-conductive strands interwoven into an open mesh with the bitumen filling the openings in the mesh. Also described is a method of electromagnetically shielding an enclosure defined by a plurality of walls, by: applying to one or more walls of the enclosure bitumen panels of electromagnetic shielding material having two layers of bitumen bonded to, and on opposite sides of, an electromagnetic screen of a plurality of electrically-conductive strands interwoven into an open mesh with the bitumen filling the openings in the mesh. Further described is a method of shielding an enclosure defined by a plurality of walls, by applying to one or more walls of the enclosure an electromagnetic screen including a plurality of electrically-conductive strands interwoven into an open mesh; and applying a layer of plaster over the screen.

## Description

### FIELD AND BACKGROUND OF THE PRESENT INVENTION

The present invention relates to methods of electromagnetically shielding buildings and other enclosures. The invention also relates to bitumen panels (includes sheets as used herein) useful in such methods.

Electromagnetic shielding is commonly used for shielding sensitive electronic equipment from outside electromagnetic radiation. Such shielding usually includes a metal layer, such as a layer of aluminum, lining the enclosure or the part of the enclosure to be protected from outside electromagnetic radiation.

Outside electromagnetic radiation, however, can also have a serious negative influence on the health of individuals exposed to such radiation. For example, studies have shown that individuals residing in buildings closely located to high voltage power lines suffer from higher rates of cancer than others. There is also a high degree of suspicion and apprehension that the electromagnetic radiation involved in cellular telephony systems may have an accumulative effect over a period of time on the health of those exposed to such radiation.

Recently, publicity has been given to the inclusion of an electromagnetic screen of interwoven electrically-conductive strands in window drapes to provide shielding against external electromagnetic radiation. However, such a product provides electromagnetic shielding only with respect to external radiation at the window regions of the building or other enclosure, and no protection with respect to such radiation entering the building structure or enclosure from other directions.

### OBJECTS AND BRIEF SUMMARY OF THE PRESENT INVENTION

An object of the present invention is to provide a method of electromagnetically shielding a building or other enclosure from external electromagnetic radiation, which method may be used for converting an existing building or other enclosure to one shielded from external electromagnetic radiation. Another object is to provide a method of building an electromagnetically shielded building or other enclosure. A still further object is to provide shielding panels (or sheets) for use in converting an existing building or other enclosure to a shielded enclosure, or for building a shielded building or other enclosure.

According to one aspect of the present invention, there is provided a panel or sheet of electromagnetic shielding material for use in shielding a building structure or other enclose from electromagnetic radiation, the panel or sheet comprising two layers of bitumen bonded to, and on opposite sides of, an electromagnetic screen including a plurality of electrically-conductive strands interwoven into an open mesh with the bitumen filling the openings in the mesh.

According to further features in the described preferred embodiment, the interwoven electrically-conductive strands are of a diameter of about 0.15 to 0.5 mm, define an open mesh having openings of 1 to 2 mm², and cover about 20 to 30 per cent of the area of the screen. Particularly good results are obtainable when the interwoven electrically-conductive strands are of a diameter of 0.2 mm, define an open mesh having openings of 1.955 mm², and cover 23.6 per cent of the area of the screen.

According to another aspect of the present invention, there is provided a method of electromagnetically shielding an enclosure defined by a plurality of walls, comprising applying to one or more walls of the enclosure bitumen panels or sheets of electromagnetic shielding material including two layers of bitumen bonded to, and on opposite sides of, an electromagnetic screen including a plurality of electrically-conductive strands interwoven into an open mesh with the bitumen filling the openings in the mesh.

According to a further aspect of the invention, there is provided a method of shielding an enclosure defined by a plurality of walls, comprising applying to one or more walls of the enclosure an electromagnetic screen including a plurality of electrically-conductive strands interwoven into an open mesh; and applying a layer of plaster over the screen. In one described preferred embodiment, the layer of plaster is applied as wet plaster.

It should be understood that the term "about" shall mean +/- 10% of the number it defines.

As will be described more particularly below, the invention enables existing buildings or other enclosures to be electromagnetically shielded from outside radiation at relatively low cost, and also enables the construction at relatively low cost of buildings or other enclosures which are shielded from external electromagnetic radiation.

Further features and advantages of the invention will be apparent from the description below.

### BRIEF DESCRIPTION OF THE DRAWINGS

The invention is herein described, by way of example only, with reference to the accompanying drawings, wherein:
Fig. 1 illustrates one form of electromagnetic screen which may be used in the method or panels of the present invention for electromagnetically shielding buildings or other enclosures from external radiation;
Fig. 2 illustrates a bitumen-type panel constructed in accordance with the present invention;
Fig. 3 illustrates a glass-type panel constructed with an electromagnetic shield for use as the windows of the building structure, for example;
Fig. 4 illustrates a wall of a building structure or other enclosure converted to an electromagnetically shielded wall in accordance with the present invention by the application an electromagnetic screen and dry plasterboard thereover;
Fig. 5 illustrates a wall of a building structure or other enclosure converted to an electromagnetically shielded wall in accordance with the present invention by the application of an electromagnetic screen and wet plaster thereover; and
Fig. 6 illustrates the conversion of an external wall of a building structure or other enclosure to one having electromagnetic shielding.

It is to be understood that the foregoing drawings, and the description below, are provided primarily for purposes of facilitating understanding the conceptual aspects of the invention and possible embodiments thereof, including what is presently considered to be a preferred embodiment. In the interest of clarity and brevity, no attempt is made to provide more details than necessary to enable one skilled in the art, using routine skill and design, to understand and practice the described invention. It is to be further understood that the embodiments described are for purposes of example only, and that the invention is capable of being embodied in other forms and applications than described herein.

### DESCRIPTION OF PREFERRED EMBODIMENTS

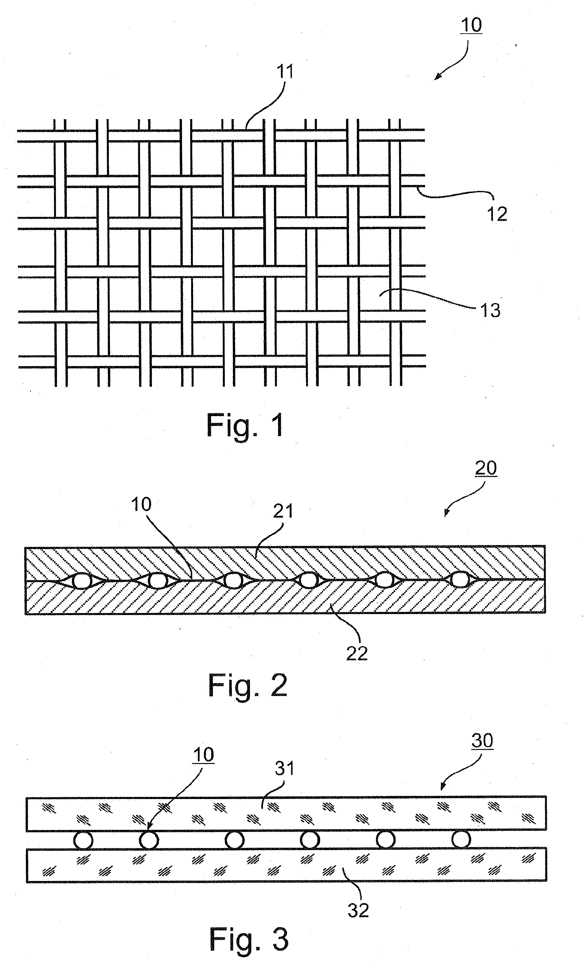

Fig. 1 illustrates an example of an electromagnetic screen which may be used for shielding buildings or other enclosures in accordance with the present invention from external electromagnetic radiation at relatively low cost. For example, such an electromagnetic screen may be applied to a wall of the building structure and then covered by an outer covering in order to convert the building structure to one electromagnetically shielded from external radiation. Alternatively, the screen illustrated in Fig. 1 may be incorporated in a panel for use in converting the building structure to an electromagnetically-shielded one, or for constructing such a building structure electromagnetically shielded from external radiation.

The electromagnetic screen 10 illustrated in Fig. 1 is constituted of a plurality of interwoven strands or wires 11, 12, of electrically-conductive material defining an open mesh having openings 13. Preferably, the electrically-conductive strands 11, 12 are of metal, such as aluminum, copper, steel, etc., but may also be of a non-metal, such as of carbon, graphite, electrically-conductive plastic, etc.

As indicated earlier, the interwoven electrically-conductive strands are of a diameter of about 0.15 to 0.5 mm, define an open mesh having openings of about 1 to 2 mm², and cover about 20-30 per cent of the area of the screen. Particularly good results are obtainable when the strands are of a diameter of 0.2 mm, define an open mesh having openings of 1.955 mm², and cover 23.6 per cent of the area of the screen.

Fig. 2 illustrates a panel, therein generally designated 20, constructed with the electromagnetic screen 10 of Fig. 1. Panel 20 is constructed of two layers 21, 22 of bitumen or the like bonded together with the electromagnetic screen 10 in between with the bitumen filling the openings in the mesh of the interwoven strands. Such a bitumen panel can be used, for example, for application to the roof or side walls of the building structure in order to provide the electromagnetic shielding of the roof and/or side walls with respect to external radiation.

Fig. 3 illustrates a panel, therein generally designated 30, including two glass layers 31, 32 bonded together with the electromagnetic screen 10 in between. It will appreciated that layers 31, 32 could also be of transparent plastic. Such a construction can be used for providing the windows, or other transparent regions of the building structure, with electromagnetic shielding;

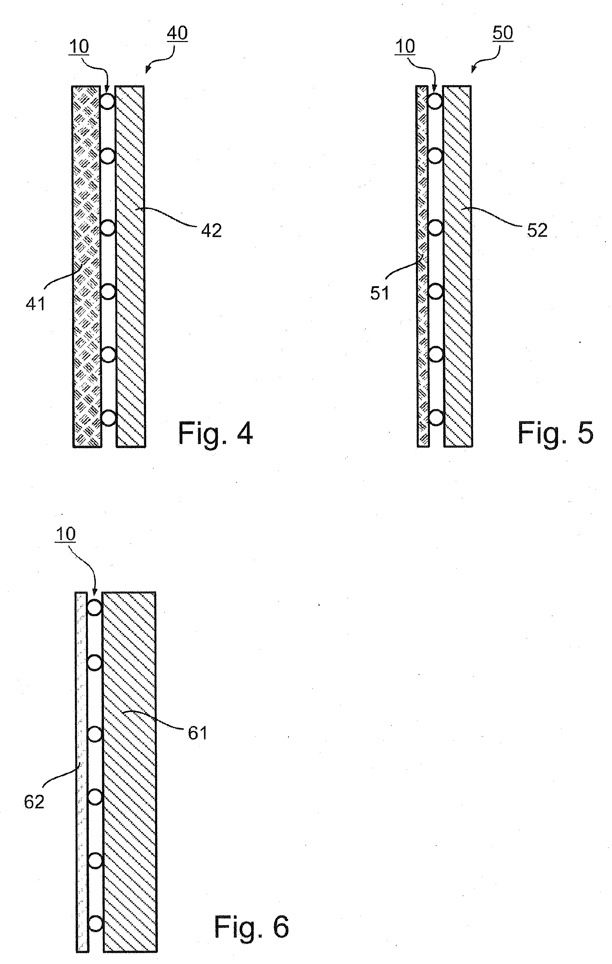

Fig. 4 illustrates a panel, therein generally designated 40, in which one or both layers 41, 42 are of dry plasterboard bonded together with the electromagnetic screen 10 in between. Such a panel may be used for electromagnetic shielding internal partition walls in a building structure or other enclosure.

Fig. 5 illustrates a panel, therein generally designated 50, including a first layer 52 of any suitable material, such as dry plasterboard, plastic, or the like, covered on one surface with the electromagnetic screen 10, which in turn is covered by a wet plaster layer 51 for bonding the electromagnetic screen to layer 52. Thus, when the wet plaster layer 51 is dried or sets, electromagnetic screen 10 is firmly bonded to the supporting layer 52 and is covered by the plaster layer 51.

Fig. 6 illustrates the electromagnetic screen 10 applied to an external wall 61 of the building structure or other enclosure, and is fixed thereto by external siding 62 bonded to the external wall 61, with the electromagnetic screen in between. Such a construction would be appropriate for converting an existing non-shielded building structure or other enclosure to one electromagnetically shielded from external radiation.

While the invention has been described with respect to several preferred embodiments, it will be appreciated that these are set forth merely for purposes of example, and that many other variations, modifications and applications of the invention may be made.

## Claims

1. A panel of electromagnetic shielding material for use in shielding a building structure or other enclosure from electromagnetic radiation, said panel comprising two layers of bitumen bonded to, and on opposite sides of, an electromagnetic screen including a plurality of electrically-conductive strands interwoven into an open mesh with the bitumen filling the openings in said mesh.

2. The panel according to Claim 1, wherein said interwoven electrically-conductive strands are of a diameter of about 0.15 to 0.5 mm.

3. The panel according to Claim 2, wherein said interwoven electrically-conductive strands define an open mesh having openings of about 1 to 2 mm².

4. The panel according to Claim 3, wherein said interwoven electrically-conductive strands cover about 20 to 30 per cent of the area of the screen.

5. The panel according to Claim 1, wherein said interwoven electrically-conductive strands are of a diameter of about 0.2 mm, define an open mesh having openings of about 1.955 mm², and cover about 23.6 per cent of the area of the screen.

6. The panel according to Claim 1, wherein said interwoven electrically-conductive strands are of a metal.

7. The panel according to Claim 1, wherein said interwoven electrically-conductive strands are of aluminum, copper or steel.

8. A method of electromagnetically shielding an enclosure defined by a plurality of walls, comprising applying to one or more walls of said enclosure bitumen panels of electromagnetic shielding material including two layers of bitumen bonded to, and on opposite sides of, an electromagnetic screen including a plurality of electrically-conductive strands interwoven into an open mesh with the bitumen filling the openings in said mesh.

9. The method according to Claim 8, wherein said interwoven electrically-conductive strands are of a diameter of about 0.15 to 0.5 mm.

10. The method according to Claim 9, wherein said interwoven electrically-conductive strands define an open mesh having openings of about 1 to 2 mm².

11. The method according to Claim 10, wherein said interwoven electrically-conductive strands cover about 20 to 30 per cent of the area of the screen.

12. The method according to Claim 8, wherein said interwoven electrically-conductive strands are of a diameter of 0.2 mm, define an open mesh having openings of 1.955 mm², and cover 23.6 per cent of the area of the screen.

13. The method according to Claim 8, wherein said interwoven electrically-conductive strands are of a metal.

14. The method according to Claim 8, wherein said interwoven electrically-conductive strands are of aluminum, copper or steel.

15. The method according to Claim 8, wherein said bitumen panels are applied to all the walls of said enclosure.

16. A method of shielding an enclosure defined by a plurality of walls, comprising applying to one or more walls of the enclosure an electromagnetic screen including a plurality of electrically-conductive strands interwoven into an open mesh; and applying a layer of plaster over said screen.

17. The method according to Claim 16, wherein said layer of plaster is applied as wet plaster.

18. The method according to Claim 16, wherein said interwoven electrically-conductive strands are of a diameter of about 0.15 to 0.5 mm.

19. The method according to Claim 18, wherein said interwoven electrically-conductive strands define an open mesh having openings of about 1 to 2 mm².

20. The method according to Claim 19, wherein said interwoven electrically-conductive strands cover about 20 to 30 per cent of the area of the screen.

21. The method according to Claim 16, wherein said interwoven electrically-conductive strands are of a diameter of 0.2 mm, define an open mesh having openings of 1.955 mm², and cover 23.6 per cent of the area of the screen.

22. The method according to Claim 16, wherein said interwoven electrically-conductive strands are of a metal.

23. The method according to Claim 16, wherein said interwoven electrically-conductive strands are of aluminum, copper or steel.

24. The method according to Claim 16, wherein said bitumen panels are applied to all the walls of said enclosure.
